# EUROPEAN PATENT APPLICATION

(11) **EP 0 908 987 A2**
(43) Date of publication of application: **14.04.1999**
(21) Application number: 98117465.9
(22) Date of filing: 15.09.1998
(51) Int. Cl.: H01S 3/19, H01L 33/00

(54) **Method for manufacturing semiconductor element**

(30) Priority: 30.09.1997 JP 265941/97
(71) Applicant: NEC CORPORATION, Tokyo (JP)
(72) Inventor: Koui, Tomoaki, c/o NEC Corporation, Minato-ku, Tokyo (JP)
(74) Representative: Glawe, Delfs, Moll & Partner

(57) **Abstract**

When crystal layers of a guide layer, a spacer layer, and an MQW layer are formed successively on an InP substrate having a corrugation grating by MOVPE process, the heating profile of the substrate is such that the temperature of the substrate reaches the growth temperature of the crystal layers within a short period of time, such as two minutes, and thereafter the drift of the temperature is stabilized within ±5°C. And the growth start timing of the guide layer of InGaAsP is set so that the growth of the guide layer is started before the mass transport of indium is activated.

## Description

### BACKGROUND OF THE INVENTION

### 1. Field of the Invention

This invention relates to a method for manufacturing a semiconductor element, and more particularly to a method for manufacturing a distribution feed back type semiconductor laser (hereinafter referred to as DFB laser) which has a corrugation grating therein.

### 2. Description of the Related Art

In a DFB laser element, it is an important factor to single mode laser oscillations to retain the shape of the corrugation grating and control the optical refractive index. For example, when group V gas (AsH₃, PH₃) is supplied to an InP substrate having a corrugation grating during heating the InP substrate, an InAsP piling layer is deposited at concave region of the corrugation grating, which makes it difficult to retain the shape of the corrugation grating. As a result, an desired optical refractive index cannot be secured and single mode laser oscillations may not be effected. Therefore, various techniques for preserving the shape of a corrugation grating have been proposed, and it is a conventional practice to adjust the flow rate of group V gas during heating as disclosed, for example, in IPRM '97, ThB5, 1997.

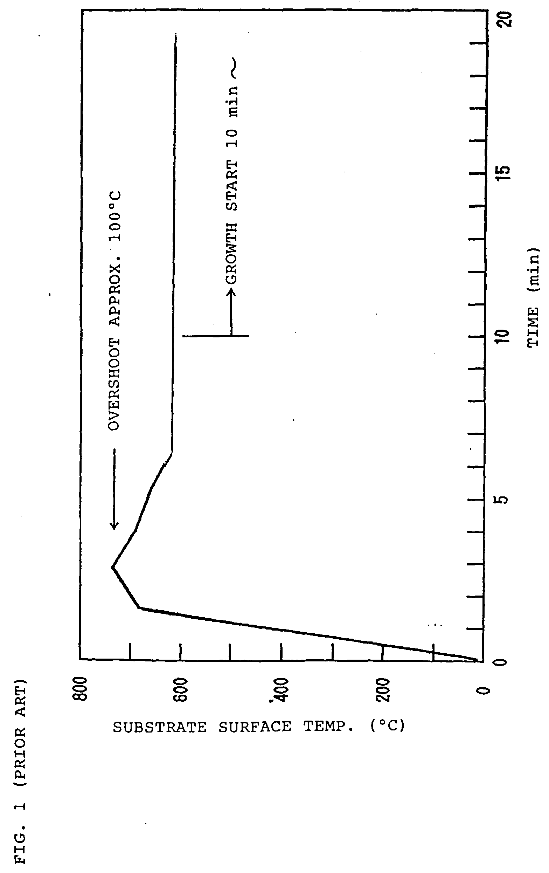

Fig. 1 is a diagram showing an ordinary heating profile when a guide layer is formed on an InP substrate by a conventional method, which has a corrugation grating, using a metal organic vapor phase epitaxial growth (hereinafter referred to as MOVPE) process. While Fig. 1 shows an example of a heating profile by a low pressure MOVPE growth system, the temperature is raised normally in a group V gas atmosphere, and after the substrate temperature is stabilized sufficiently, the growth of a guide layer is started as shown in Fig. 1. The reason why this procedure is taken is that, upon heating, an overshoot (in which the substrate temperature becomes higher than the growth temperature of guide layer) of tens degrees to 100°C occurs, and hence in order to achieve the stabilization of substrate temperature, the group V holding time is set to approximately 10 minutes. Further, the flow rate of group V gas in the holding condition during heating is adjusted to retain the shape of the corrugation grating.

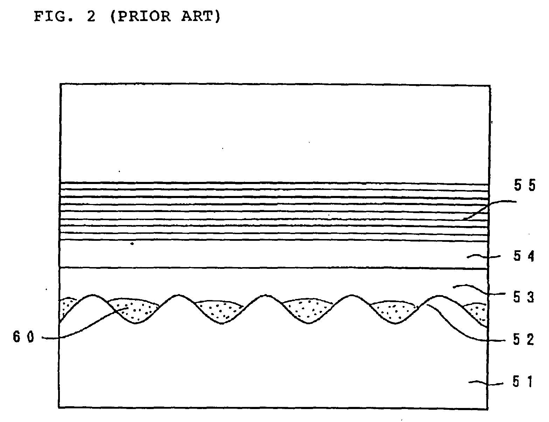

Although a countermeasure to preserve the shape of a corrugation grating has been developed in that manner, and even when a DFB laser is actually manufactured using the technique as described above, actually an anticipated effect cannot be achieved. Fig. 2 is a schematic sectional view of a DFB laser element when a double hetero structure portion (hereinafter referred to as DH structure) of a DFB laser including therein a guide layer 53, InP spacer layer 54 and multilayer quantum well layer (MQW layer) 55 is crystal-grown on InP substrate 51, having a corrugation grating 52 on the surface thereof, according to the heating profile of Fig. 1 by an atmospheric pressure MOVPE growth method. As seen from Fig. 2, InAsP piling layer 60 is deposited in the concave region of the corrugation grating 52, and hence it is difficult to control the optical refractive index of the corrugation grating.

### SUMMARY OF THE INVENTION

It is an object of the present invention to provide a method for manufacturing a semiconductor element which realizes preferable preservation of the shape of a corrugation grating when crystal is grown on the corrugation grating by an atmospheric pressure MOVPE process.

The object as described above can be attained by a method for manufacturing a semiconductor element, according to the present invention, which comprises a step of forming a crystal layer on a corrugation grating formed on the surface of a substrate by a metal organic vapor phase epitaxial growth system, the method comprising any one of the following steps:
(1) The step of forming a crystal layer by the metal organic vapor phase epitaxial growth system is set such that growth of the crystal layer is started before a mass transport of an element contained in the corrugation grating is activated.
(2) The step of forming a crystal layer by the metal organic vapor phase epitaxial growth system is set such that growth of the crystal layer is started before the temperature of the substrate reaches a growth temperature of the crystal layer.
(3) The step of forming a crystal layer by the metal organic vapor phase epitaxial growth system is set such that growth of the crystal layer is started immediately after the temperature of the substrate reaches a growth temperature.
(4) In the step of forming a crystal layer by the metal organic vapor phase epitaxial growth system, a temperature rise profile which has no overshoot is used.
(5) In the step of forming a crystal layer by the metal organic vapor phase epitaxial growth system, a heating profile such that the temperature of the substrate reaches a growth temperature in a short time without exhibiting an overshoot and thereafter the temperature drift is sufficiently small is used. In this instance, preferably the temperature of the substrate reaches the growth temperature in a short time of 2 minutes or less without exhibiting an overshoot and the temperature drift thereafter is stabilized within ±5°C.

Such InAsP piling layer deposited on a corrugation grating as described above arises from an excessive mass transport of In, and when the thermal mass transport is activated by an overshoot with group V atmosphere, surface migration of In is promoted. Therefore, by achieving optimization of the heating profile and group V holding time, to which little attention has been paid until now, as provided by the features described in (1) to (5) given above, the mass transport of In can be suppressed, so that the formation of a piling layer can be limited and hence a good corrugation grating shape can be preserved. Specifically, in the present invention, the manufacturing method is characterized in that the holding temperature with group V atmosphere is controlled lower than a temperature at which a thermal mass transport is activated.

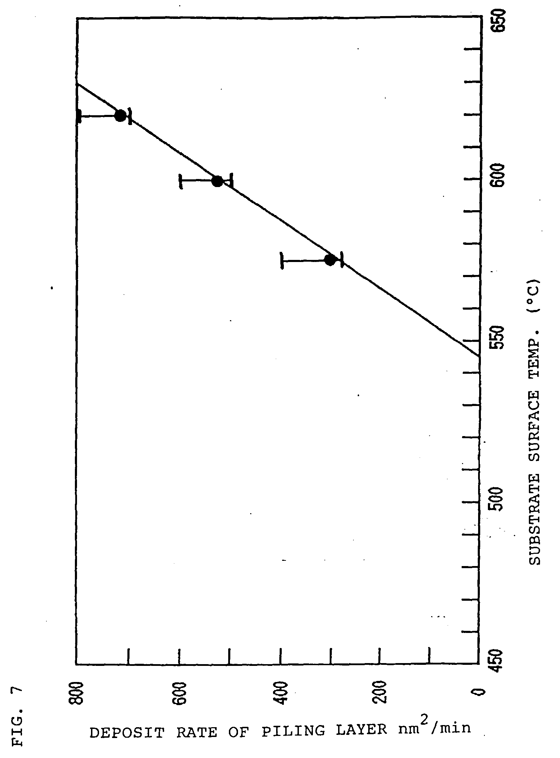

Here, Fig. 7 shows a graph of an estimated relationship between the deposition rate of a piling layer and substrate temperature. Referring to Fig. 7, the relationship between the deposition rate of the piling layer and the substrate temperature can be represented by linear approximation, and it can be estimated that the temperature at which a thermal mass transport is activated ranges from 500°C to 550°C. Accordingly, if the holding temperature with group V atmosphere is set lower than 550°C and growth of guide layer is started immediately after 550°C is exceeded, then no piling layer is produced. In other words, no piling layer is produced if the holding time with the group V atmosphere is set to the time it takes for the temperature to reach 550°C (reduction of the time) and the growth is started immediately after 550°C is exceeded. And the heating time it takes for the temperature of substrate to reach the growth temperature from temperature of 500°C to 550°C is very short and approximately 30 seconds to one minute. Taking into account of the fact that, with an MOVPE system, it is difficult to form a good single crystal at such a low temperature as 500°C to 550°C, no piling layer will be produced even if the holding temperature is set lower than the growth temperature. Furthermore, such effect can be obtained also by suppressing such an overshoot as seen from Fig. 1.

The above and other objects, features, and advantages of the present invention will become apparent from the following description referring to the accompanying drawings which illustrate examples of preferred embodiments of the present invention.

### BRIEF DESCRIPTION OF THE DRAWINGS

Fig. 1 is a heating profile showing an example of a conventional method;
Fig. 2 is a sectional view of a DFB laser element manufactured by the conventional method;
Fig. 3 is a heating profile according to a first embodiment of the present invention;
Fig. 4 is a temperature rise profile according to a second embodiment of the present invention;
Fig. 5 is a temperature rise profile according to a third embodiment of the present invention;
Fig. 6 is a sectional view of a DFB laser element manufactured by the method of the present invention; and
Fig. 7 is a graph of an estimated relationship between the deposition rate of a piling layer and the substrate temperature.

### DETAILED DESCRIPTION OF THE PREFERRED EMBODIMENTS

First, a first embodiment is described. An InP substrate on which a corrugation grating is formed beforehand is set in an atmospheric MOVPE growth apparatus. The corrugation grating is formed on the surface of the InP substrate by a two-beam interference exposure method. Here, the shape of the corrugation grating has a depth of 60 nm and a pitch of 203 nm. Further, the atmospheric MOVPE crystal growth apparatus has a growth pressure of 760 Torr and employs, as a heating method, a heater resistor heating system. The InP substrate is held by a susceptor and heated by the heater from behind the susceptor. Meanwhile, control of the substrate surface temperature is performed by feeding back the temperature of a thermocouple in the susceptor to the heater temperature. Further, the substrate surface temperature can be measured directly using a pyrometer. Accordingly, a desired profile can be produced freely by particularly determining the correlation between the temperature of the thermocouple in the susceptor and the substrate surface temperature sensed by the pyrometer.

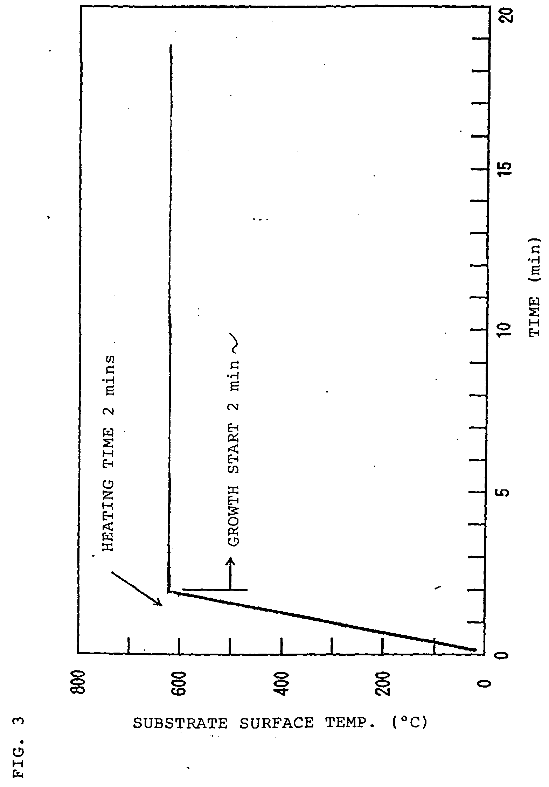

In the present first embodiment, as seen from a heating profile and a guide layer growth starting timing shown in Fig. 3, the correlation between the temperature of the thermocouple in the susceptor and the substrate surface temperature during heating detected by the pyrometer is determined precisely to prepare a heating profile such that the surface temperature with group V atmosphere reaches a growth temperature (625°C) in two minutes without causing an overshoot and, after the growth temperature is reached, the temperature drift is stabilized within ±5°C. Then, simultaneous with the start of heating, the supply of group V gas is started, and immediately after the substrate temperature is stabilized at the growth temperature of 625°C, crystal growth of a guide layer is started. In the present embodiment, gas flow rate conditions during the heating are: group V gas flow rates of AsH3: 1.5 cc/min, PH3: 150 cc/min, hydrogen carrier flow rate: 30 liter/min.

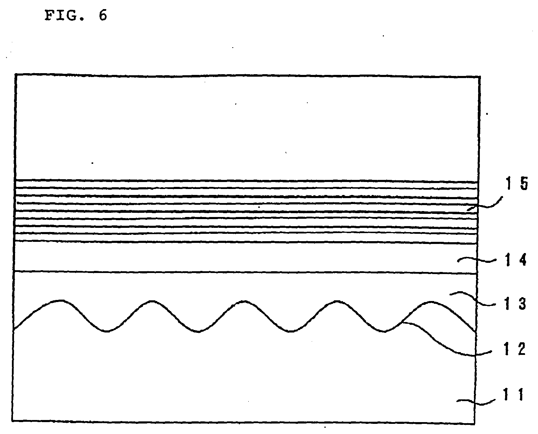

Fig. 6 is a schematic sectional view of a DH structure prepared by heating an InP substrate 11 having corrugation grating 12 and successively forming an InGaAsP guide layer 13, InP spacer layer 14, MQW layer 15 and so forth on a corrugation grating 12, in the first embodiment. As can be seen from Fig. 6, no InAsP piling layer is deposited in the concave region of the corrugation grating 12 so that the corrugation grating 12 can retain its shape. In the present embodiment, both of the reduction of the heating time with group V atmosphere, which is effective to suppress excessive mass transport of In, and the reduction of the substrate surface temperature during the holding with group V atmosphere can be achieved, and hence the amount of InAsP piling layer during heating can be effectively reduced.

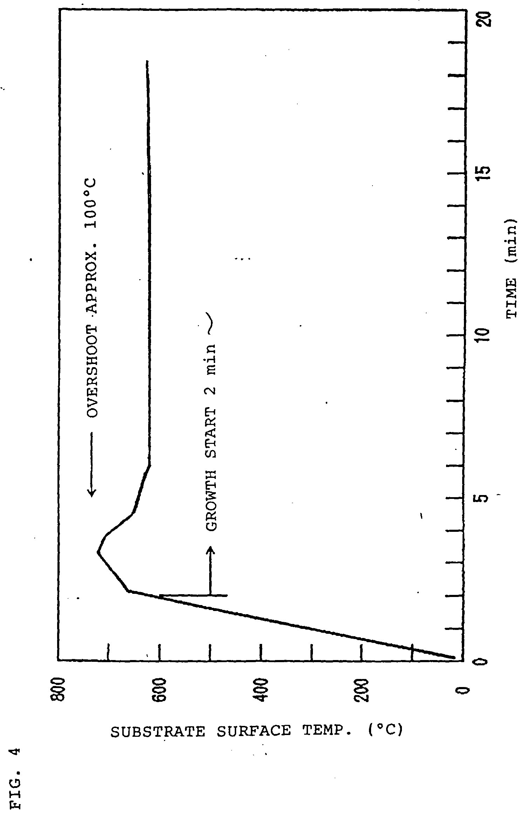

Fig. 4 shows a heating profile and a guide layer growth starting timing in a second embodiment of the present invention. The second embodiment achieves reduction of the heating with group V atmosphere. That is, the correlation between the temperature of a thermocouple in a susceptor and the substrate surface temperature during the heating detected by a pyrometer is determined precisely, and the crystal growth of a guide layer is started within the time, i.e., 2 minutes, required for the surface temperature of the substrate to reach growth temperature (625°C) from room temperature, during heating with group V atmosphere. In the conventional heating profile, the time required for the surface temperature to reach the growth temperature of 625°C is approximately 2 minutes. Particularly the time required for the surface temperature to reach 625°C from 500°C, in which indium begins to react with As and P, is approximately 25 seconds. The amount of the piling layer deposited during such time is negligibly small. Since, according to the MOVPE system, a good single crystal cannot be easily formed at a temperature lower than 500°C, while the substrate surface temperature remains within the range from 500°C to 625°C, that is, before an overshoot begins, growth of an InGaAsP guide layer is started, thereby to achieve the reduction of the time required for heating, with the result that the mass transport of indium on the surface of the corrugation grating can be suppressed and deposition of an InAsP piling layer during heating can be prevented.

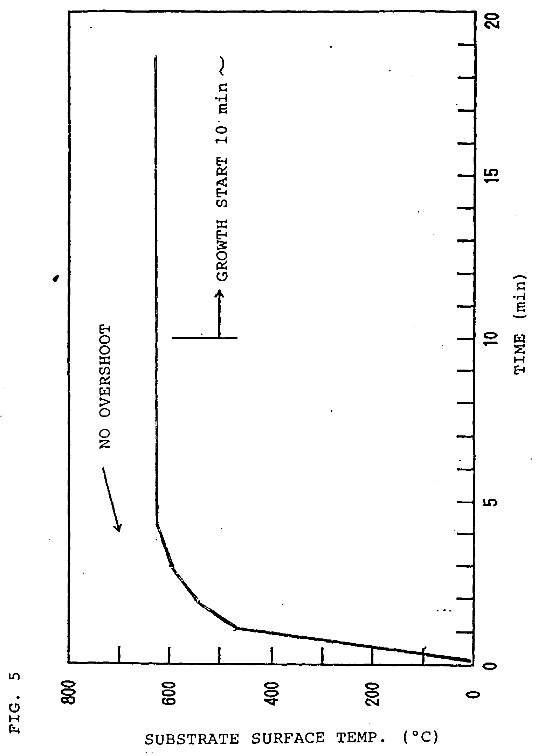

Fig. 5 shows a heating profile and a guide layer growth starting timing in a third embodiment of the present invention. In the third embodiment, an overshoot is suppressed to lower the substrate surface temperature during heating with group V atmosphere. That is, the correlation between the temperature of a thermocouple in a susceptor and the substrate surface temperature during heating detected by a pyrometer is determined precisely to prepare a heating profile such that such overshoot as to be found in the conventional example is eliminated and temperature drift is stabilized within ±5°C after a growth temperature (625°C) is reached. After the substrate temperature is stabilized sufficiently (after approximately 10 minutes elapse from the room temperature), growth of a guide layer is started. If the temperature becomes higher than the growth temperature, then the mass transport of indium is promoted and the rate of deposition of a piling layer increases, and hence, the amount of the piling layer increases progressively. By setting the substrate temperature during heating at temperatures lower than the growth temperature to eliminate an overshoot, an excessive mass transport of indium can be suppressed and deposition of an InAsP piling layer during heating can be prevented.

Here, while, in the embodiments described above, examples, wherein the present invention is applied to an atmospheric MOVPE system, are described, the present invention can be applied also to a crystal growth technique on a corrugation grating by a low pressure MOVPE system.

As described above, when a crystal layer is formed on a corrugation grating formed on the surface of a substrate by a MOVPE system, such a technique that (1) growth of a crystal layer is started before the mass transport of an element contained in a diffraction grating is activated, (2) growth of a crystal layer is started before the temperature of a substrate reaches a growth temperature, (3) growth of a crystal layer is started immediately after the temperature of the substrate reaches a growth temperature, (4) a heating profile which has no overshoot is applied to the temperature of the substrate or (5) a heating profile such that the temperature of the substrate reaches a growth temperature in a short time without exhibiting an overshoot and also a temperature drift thereafter is sufficiently small is used, is employed. By employing any one of the techniques described above, the problem that a piling layer is deposited in an upwardly swelling state at the concave region of the corrugation grating so that difficulties in the control of optical refractive index, by retaining the shape of the corrugation grating, occur can be solved, and a semiconductor element of good DFB laser characteristics can be manufactured.

## Claims

1. A method for manufacturing a semiconductor element comprising a step of forming a crystal layer on a corrugation grating formed on the surface of a substrate by a metal organic vapor phase epitaxial growth system, wherein growth of the crystal layer is started before a mass transport of an element contained in the corrugation grating is activated.

2. The method for manufacturing a semiconductor element according to claim 1, wherein the growth pressure for the crystal layer is an atmospheric pressure.

3. A method for manufacturing a semiconductor element comprising a step of forming a crystal layer on a corrugation grating formed on the surface of a substrate by a metal organic vapor phase epitaxial growth system, wherein growth of the crystal layer is started before the temperature of the substrate reaches a growth temperature.

4. The method for manufacturing a semiconductor element according to claim 3, wherein the growth pressure for the crystal layer is an atmospheric pressure.

5. A method for manufacturing a semiconductor element comprising a step of forming a crystal layer on a corrugation grating formed on the surface of a substrate by a metal organic vapor phase epitaxial growth system, wherein the growth of the crystal layer is started immediately after the temperature of the substrate reaches a growth temperature.

6. The method for manufacturing a semiconductor element according to claim 5, wherein the growth pressure for the crystal layer is an atmospheric pressure.

7. A method for manufacturing a semiconductor element comprising a step of forming a crystal layer on a corrugation grating formed on the surface of a substrate by a metal organic vapor phase epitaxial growth system, wherein a heating profile which has no overshoot is used in said step of forming a crystal layer.

8. The method for manufacturing a semiconductor element according to claim 7, wherein the growth pressure for the crystal layer is an atmospheric pressure.

9. A method for manufacturing a semiconductor element comprising a step of forming a crystal layer on a corrugation grating formed on the surface of a substrate by a metal organic vapor phase epitaxial growth system, wherein a heating profile, in which the temperature of the substrate reaches a growth temperature in a short time without exhibiting an overshoot and thereafter a temperature drift is sufficiently small is used.

10. The method for manufacturing a semiconductor element according to claim 9, wherein the temperature of the substrate reaches the growth temperature within 2 minutes without exhibiting an overshoot and the temperature drift thereafter is stabilized within ±5°C.

11. The method for manufacturing a semiconductor element according to claim 9, wherein the growth pressure for the crystal layer is an atmospheric pressure.

12. The method for manufacturing a semiconductor element according to claim 10, wherein the growth pressure for the crystal layer is an atmospheric pressure.
